# EUROPEAN PATENT APPLICATION

(11) **EP 1 634 712 A2**
(43) Date of publication of application: **15.03.2006**
(21) Application number: 05018218.7
(22) Date of filing: 23.08.2005
(51) Int. Cl.: B41J 3/407, B41J 2/21, B41M 3/00, G02B 5/20

(54) **Liquid crystal filter manufacturing apparatus having an inkjet head and method for controlling the inkjet head**

(30) Priority: 10.09.2004 JP 2004263561
(71) Applicant: Toshiba Tec Kabushiki Kaisha, Tokyo 141-8664 (JP)
(72) Inventor: Takamura, Jun c/o Intellectual Property Division, Shinagawa-ku Tokyo 141-8664 (JP)
(74) Representative: Fuchs Mehler Weiss & Fritzsche

(57) **Abstract**

An apparatus for manufacturing liquid crystal filters, the apparatus having an inkjet head such that when nozzles (11a,11b,..., and 11n) of the inkjet head (10) face cells (3) of a liquid crystal filter (2), respectively, several ink (Q) droplets having small sizes are continuously ejected from each nozzle. The several ink (Q) droplets are securely accommodated in and applied to each of the cells (3) without hitting a circumferential portion of the cell (3) and thereby break.

## Description

The present invention relates to an apparatus for manufacturing a liquid crystal filter which constitutes a screen of a liquid crystal display or the like.

In a liquid crystal filter constituting a screen of a liquid crystal display or the like, plural concave cells (also referred to as elements) are arrayed in an upper surface of a translucent plate-shaped member, and coloring ink ejected from an inkjet head is thrown into and applied to each cell (for example, see Jpn. Pat. Appln. KOKAI Publication Nos. 9-30664, 2001-108820, and 2002-273868). Examples of the coloring ink include red (R), green (G), and blue (B) color ink.

The ink ejected from the inkjet head is thrown into the cell while the ink is formed in one large droplet. At this point, since the thrown ink droplet has a large size, sometimes the ink droplet is broken by hitting a circumferential portion of the cell. A part of the broken ink droplet is splattered to adhere to a region between the cell and the adjacent cell or to flow into the adjacent cell. Therefore, the quality of the liquid crystal filter is remarkably decreased.

In view of the foregoing, an object of the invention is to provide a liquid crystal filter manufacturing apparatus which can accommodate ink ejected from an inkjet head in each cell to securely apply the ink without splattering the ink, and thereby a decrease in the quality of the liquid crystal filter can be prevented.

A liquid crystal filter manufacturing apparatus according to one aspect of the present invention comprises:
an inkjet head having a plurality of nozzles to eject coloring ink to each cell of a liquid crystal filter, the inkjet head being moved relative to the liquid crystal filter; and
controller which continuously ejects several small ink droplets from each nozzle when each nozzle of the inkjet head faces each cell of the liquid crystal filter, so that the ink droplets are not combined together before the ink droplets land on the cell of the liquid crystal filter.

This summary of the invention does not necessarily describe all necessary features so that the invention may also be a sub-combination of these described features.

The invention can be more fully understood from the following detailed description when taken in conjunction with the accompanying drawings, in which:
FIG. 1 shows a configuration of first and second embodiments of the invention;
FIG. 2 shows specific configurations of an inkjet head and a head drive unit in each embodiment;
FIG. 3 is a flowchart for explaining operations of the first and second embodiments;
FIG. 4 is a timing chart for explaining operations of the first embodiment;
FIG. 5 shows a state in which four ink droplets are continuously ejected from each nozzle of the inkjet head in each embodiment;
FIG. 6 shows a state in which ink is accommodated in and applied to each cell of a liquid crystal filter in each embodiment;
FIG. 7 shows a state in which one large ink droplet is ejected from each nozzle of the inkjet head for reference purposes;
FIG. 8 shows a state in which the ink is splattered when the one large ink droplet is ejected from each nozzle of the inkjet head;
FIG. 9 shows a configuration of the inkjet head in the second embodiment;
FIG. 10 is a timing chart for explaining the operation of the second embodiment;
FIG. 11 shows a configuration of a third embodiment of the invention;
FIG. 12 a flowchart for explaining the operation of the third embodiment;
FIG. 13 is a state transition view showing correspondence between each nozzle of a inkjet head and a liquid crystal filter in the third embodiment;
FIG. 14 is a state transition view continued from FIG. 13;
FIG. 15 is a state transition view continued from FIG. 14;
FIG. 16 is a state transition view continued from FIG. 15;
FIG. 17 is a state transition view continued from FIG. 16; and
FIG. 18 is a state transition view continued from FIG. 17.

Referring to the drawings, a first embodiment of the present invention will be described.

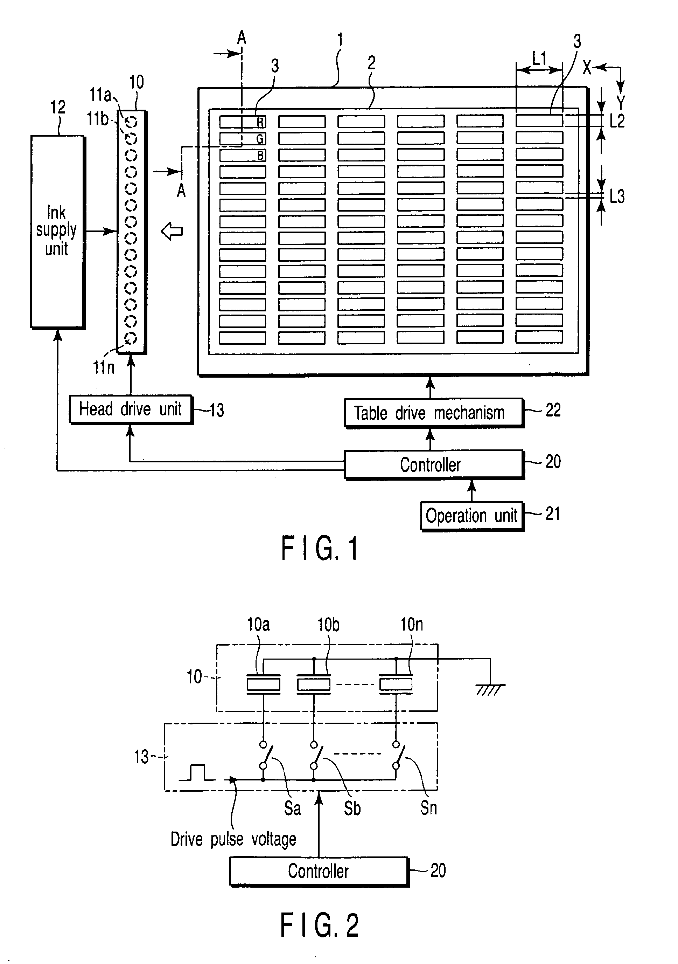

As shown in FIG. 1, a liquid crystal filter 2 is placed on a table 1 which is movable in a direction of an arrow shown by a wide line. The liquid crystal filter 2 has plural concave cells 3 on an upper surface of a translucent plate-shaped member. The cells 3 are arrayed in a matrix shape along a moving direction (X-direction) of the liquid crystal filter 2 and along a direction (Y-direction) orthogonal to the moving direction. Each of the cells 3 is formed in a rectangle. The length in a longitudinal direction along the moving direction (X-direction) of the liquid crystal filter 2 is set at L1, and the length in a crosswise direction along the direction (Y-direction) orthogonal to the moving direction of the liquid crystal filter 2 is set at L2. The pitch between the adjacent cells 3 is set at L3 in the direction (Y-direction) orthogonal to the moving direction of the liquid crystal filter 2.

An inkjet head 10 that can form one pixel by applying a plurality of several ink droplets is provided on the side toward which the liquid crystal filter 2 is moved. The inkjet head 10 has a long rectangular shape extending in the direction (Y-direction) orthogonal to the moving direction of the liquid crystal filter 2. The inkjet head 10 is arranged on a moving path of the liquid crystal filter 2 while crossing the moving path. Plural nozzles 11a, 11b, ..., and 11n are provided in a lower surface of the inkjet head 10. The nozzles are arranged in line with constant intervals along the direction (Y-direction) orthogonal to the moving direction of the liquid crystal filter 2. In consideration of the pitch L3 between the cells 3 on the liquid crystal filter 2, the interval is previously determined so that each nozzle and each cell 3 faces each other when the liquid crystal filter 2 is moved directly below the inkjet head 10.

The inkjet head 10 has oscillators 10a, 10b, ..., 10n shown in FIG. 2. The inkjet head 10 distributes red (R), green (G), and blue (B) color inks, which are supplied from an ink supply unit 12, among the nozzles 11a, 11b, ..., and 11n to selectively eject the distributed ink from the nozzles 11a, 11b, ..., and 11n by the selective operation of the oscillators 10a, 10b, ..., and 10n. Namely, the ink is ejected from the nozzle 11a when the oscillator 10a is activated, the ink is ejected from the nozzle 11b when the oscillator 10b is activated, and the ink is ejected from the nozzle 11n when the oscillator 10n is activated.

A head drive unit 13 is provided in order to drive the oscillators 10a, 10b, ..., and 10n of the inkjet head 10. The head drive unit 13 has switches Sa, Sb, ..., and Sn corresponding to the oscillators 10a, 10b, ..., and 10n. The head drive unit 13 supplies a drive pulse voltage to the oscillators 10a, 10b, ..., and 10n when the switches are turned on. For example, when the four drive pulse voltages are supplied to the oscillator 10a by turning on the switch Sa, the oscillator 10a repeats short-time operation four times to continuously eject the four ink droplets having small sizes from the nozzle 11a. Similarly, when the four drive pulse voltages are supplied to the oscillator 10a by turning on the switch Sb, the oscillator 10b repeats the short-time operation four times to continuously eject the four ink droplets having the small sizes from the nozzle 11b, and the pixel of one cell is formed.

A controller 20 controls the whole of the apparatus. The ink supply unit 12, the head drive unit 13, an operation unit 21, and a table drive mechanism 22 are connected to the controller 20. The table drive mechanism 22 moves the table 1 to a position according to a control command from the controller 20.

The controller 20 has the following means (1) and (2):
(1) Means for determining a positional relationship between the nozzles 11a, 11b, ..., and 11n of the inkjet head 10 and the cells 3 of the liquid crystal filter 2 by computation through the control of the table drive mechanism 22.
(2) Control means for continuously ejecting the several (for example, four) ink droplets having small sizes by turning on the switches Sa, Sb, ..., and Sn of the head drive unit 13 for predetermined time intervals (for example, intervals corresponding to the four drive pulse voltages) based on the computation of the positional relationship.

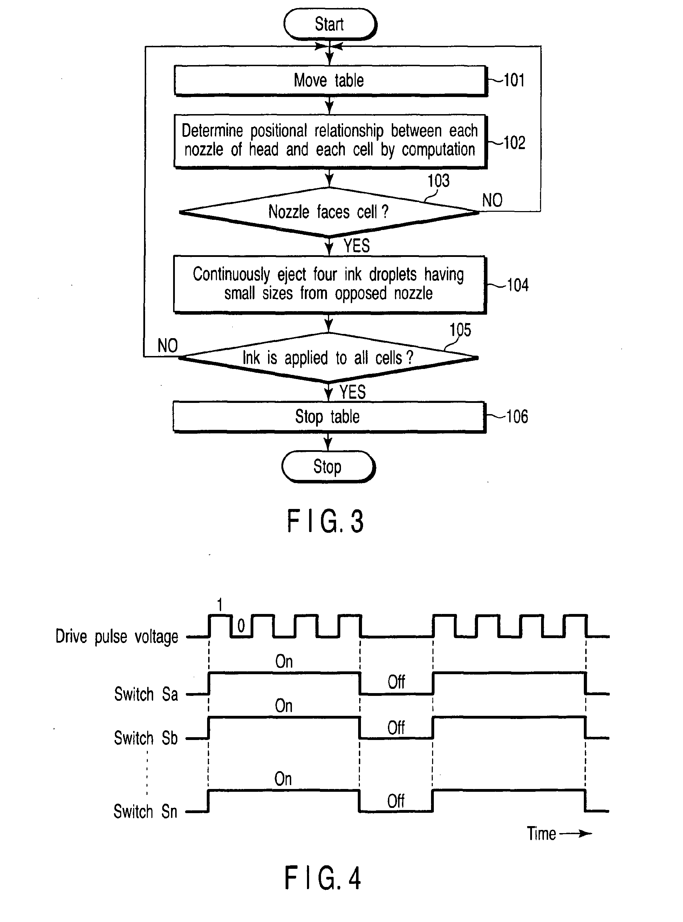

The, referring to a flowchart of FIG. 3 and a timing chart of FIG. 4, the operation will be described.

The table 1 is moved toward the side the inkjet head 10 by the operation of the table drive mechanism 22 (Step 101). According to the movement of the table 1, the positional relationship between the nozzles 11a, 11b, ..., and 11n of the inkjet head 10 and the cells 3 of the liquid crystal filter 2 is determined by the computation (Step 102).

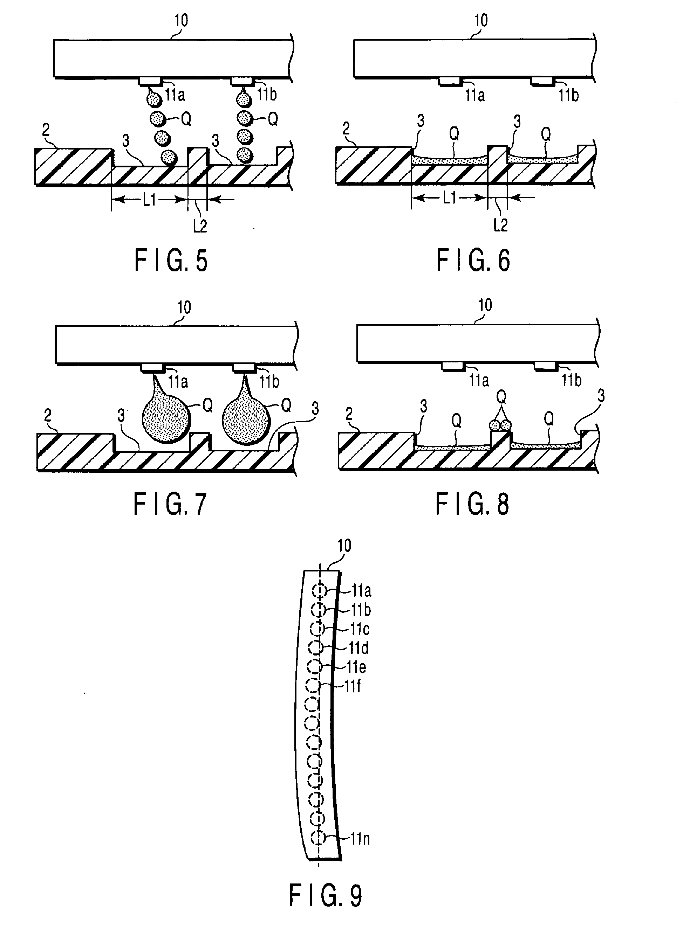

When the nozzles 11a, 11b, ..., and 11n of the inkjet head 10 face the cells 3 in a first line of the liquid crystal filter 2, respectively (YES in Step 103), the switches Sa, Sb, ..., and Sn of the head drive unit 13 are turned on for the time intervals corresponding to the four drive pulse voltages. Therefore, the four ink droplets having small sizes are continuously ejected from the nozzles 11a, 11b, ..., and 11n. FIG. 5 shows the state in which the ink droplets are ejected. FIG. 5 is a sectional view taken on line A-A of FIG. 1 when viewed from the arrow direction.

As shown in FIG. 5, the four ink droplets Q having small sizes, which are continuously ejected so that the ink droplets Q are not combined before the ink droplets land on the cell, are thrown into each of the cells 3 in the first line. At this point, since the thrown ink droplets have small sizes, the ink droplets are not broken by hitting the circumferential portion of the cell 3, but the ink droplets are securely accommodated in and applied to the cell 3. FIG. 6 shows the state in which the ink is applied.

FIG. 7 shows the state in which the one large ink droplet Q is ejected from each nozzle for reference purposes. In this case, since the ejected droplet has the large size, sometimes the ink droplet is broken by hitting the circumferential portion of the cell 3. As shown in FIG. 8, a part of the broken ink droplet is splattered to adhere to the region between the cell and the adjacent cell 3 or to flow into the adjacent cell 3 to mix with another color ink Q.

According to the first embodiment, the four ink droplets Q having small sizes are continuously ejected from each nozzle. The ink droplets Q are securely accommodated in and applied to the cell 3 without splattering around the perimeter. Therefore, a decrease in quality is not generated in the liquid crystal filter 2.

When the nozzles 11a, 11b, ..., and 11n of the inkjet head 10 face the cells 3 in a second line of the liquid crystal filter 2, respectively (YES in Step 103), the four ink droplets Q having small sizes are continuously ejected from each nozzle again.

When the ink droplets Q are applied to all the cells 3 in the liquid crystal filter 2 (YES in Step 105), the movement of the table 1 is stopped (Step 106).

A second embodiment of the invention will be described below.

In manufacturing the inkjet head 10, sometimes deformation such as warpage is generated in the inkjet head 10. In this case, as shown in FIG. 9, position deviation occurs in the nozzles 11a, 11b, ..., and 11n, which causes the nozzles not to be arranged in line shown by an alternate long and short dash line. The position deviation of each nozzle is found by an operator.

When the operator finds the position deviation of each nozzle, data indicating the position deviation of each nozzle is input to the controller 20 by operating the operation unit 21. The controller 20 adjusts ejection timing of the ink droplet Q in each nozzle based on the input data.

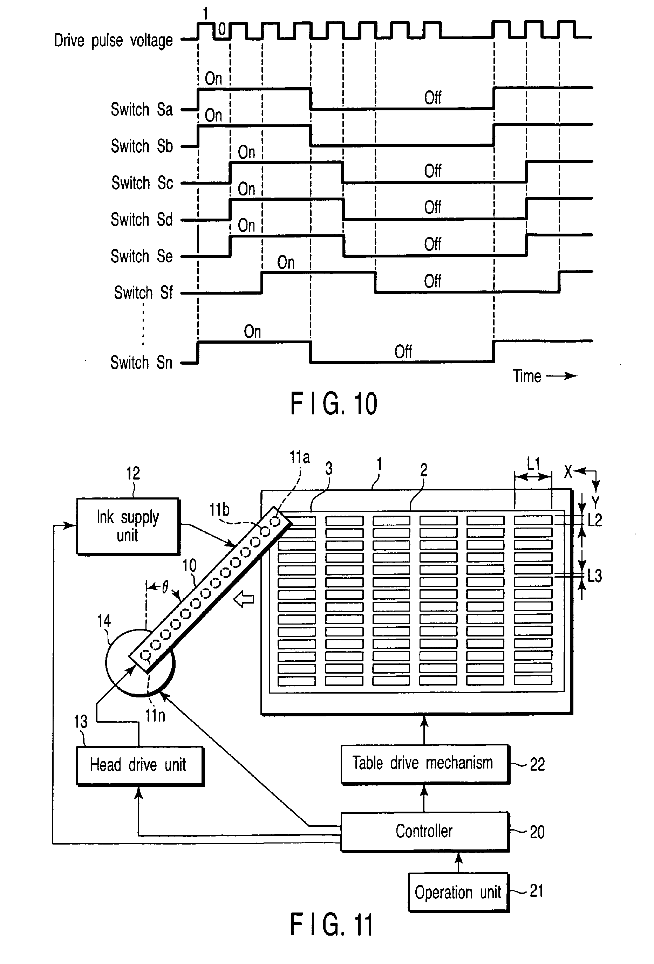

Referring to a timing chart of FIG. 10, the operation will be described below.

Since the nozzles 11a and 11b are located at proper positions on the alternate long and dash line, the switches Sa and Sb are turned on at normal timing. Therefore, the four ink droplets Q having small sizes are continuously ejected from each of the nozzles 11a and 11b at the normal timing.

The positions of the nozzles 11c, 11d, and 11e are deviated toward the moving direction (X-direction) side of the liquid crystal filter 2 from the proper positions on the alternate long and dash line. Therefore, the switches Sc, Sd, and Se are turned on while delayed by one drive voltage pulse rather than the normal timing. Therefore, the four ink droplets Q having small sizes are continuously ejected from each of the nozzles 11c, 11d, and 11e by one drive voltage pulse rather than the normal timing.

The position of the nozzle 11f is slightly deviated toward the moving direction (X-direction) side of the liquid crystal filter 2 from the positions of the nozzles 11c, 11d, and 11e. Therefore, the switch Sf is turned on while delayed by two drive voltage pulses rather than the normal timing, which allows the four ink droplets Q having small sizes to be continuously ejected from the nozzle 11f by two drive voltage pulses rather than the normal timing.

Thus, by adjusting the ejection timing of the ink droplet Q of each nozzle, the ink droplets Q can securely be accommodated in and applied to the cell 3 irrespective of the position deviation of each nozzle.

Other configurations, operations, and effects are similar to the first embodiment.

A third embodiment of the invention will be described below.

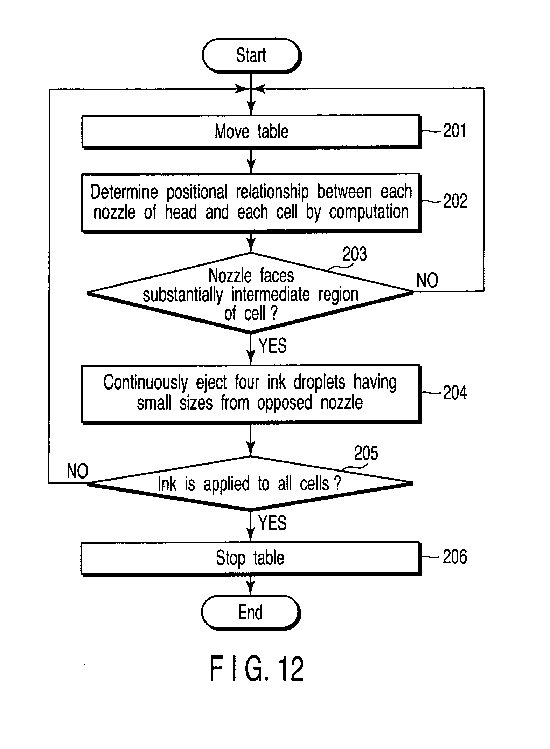

As shown in FIG. 11, a head rotation mechanism 14 is coupled to the inkjet head 10. The head rotation mechanism 14 rotates the inkjet head 10 to an angle according to a control command from the controller 20. The operator can set the rotation angle of the inkjet head 10 with the operation unit 21.

When the pitch L3 between the cells 3 in the liquid crystal filter 2 is small (high-resolution type liquid crystal filter), the operator performs the rotation operation of the inkjet head 10. The rotation operation inclines the line of the nozzles 11a, 11b, ..., and 11n of the inkjet head 10 by a predetermined angle θ with respect to the direction (Y-direction) orthogonal to the moving direction of the liquid crystal filter 2.

Even if the pitch L3 between the cells 3 is small, the nozzles 11a, 11b, ..., and 11n can securely face the cells 3 respectively by inclining the line of the nozzles 11a, 11b, ..., and 11n by the predetermined angle θ.

The controller 20 has the following means (11) and (12) as the main function:
(11) Means for determining a positional relationship between the nozzles 11a, 11b, ..., and 11n of the inkjet head 10 and the cells 3 of the liquid crystal filter 2 by the computation through the control of the table drive mechanism 22.
(12) Control means for continuously ejecting the several (for example, four) ink droplets having the small sizes by turning on any one or the plural switches corresponding to the opposite nozzles in the switches Sa, Sb, ..., and Sn of the head drive unit 13 for predetermined time intervals (for example, intervals corresponding to the four drive pulse voltages) based on the computation of the positional relationship, when any one or the plural nozzles face a substantially intermediate region of the cell 3.

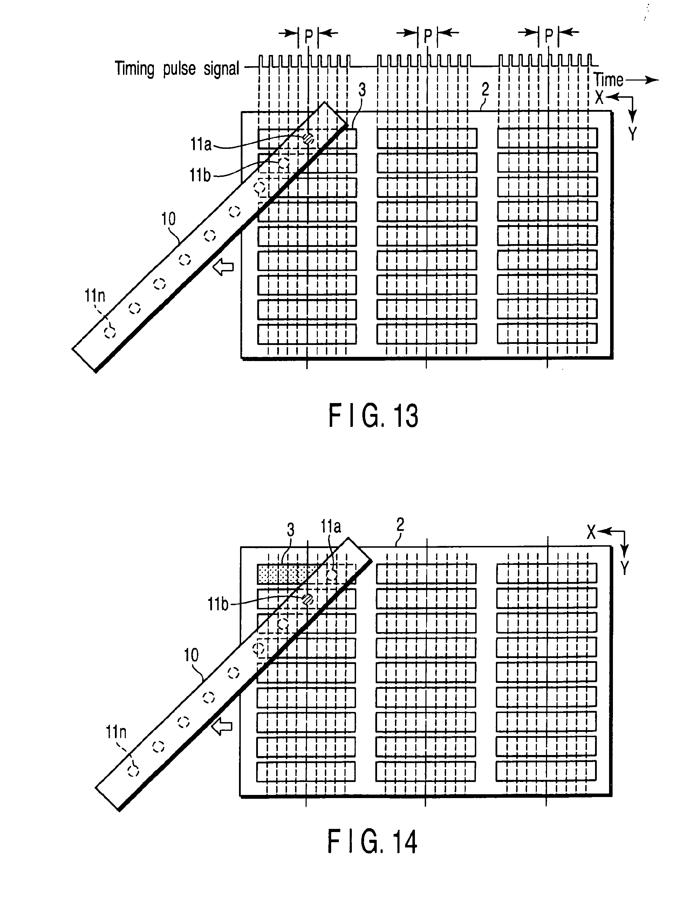

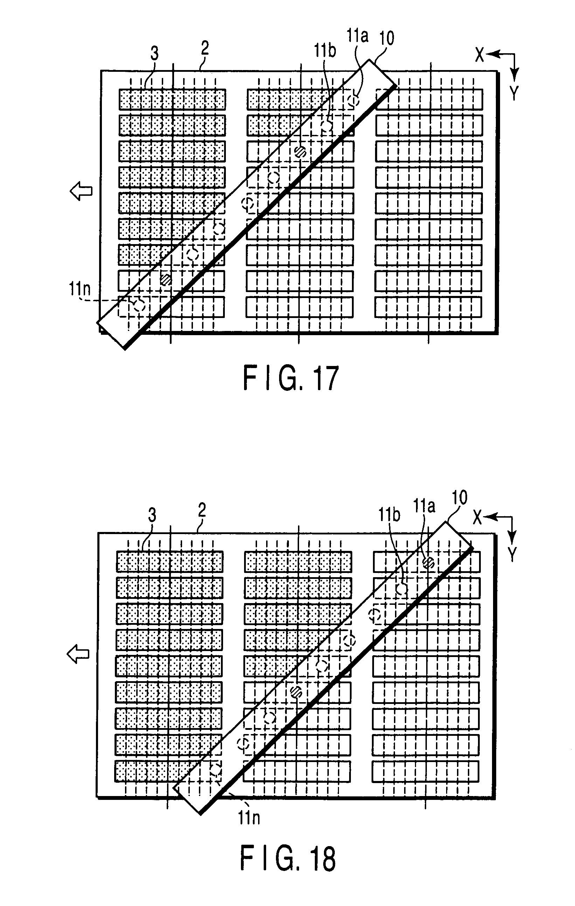

Referring to a flowchart of FIG. 12 and state transition views of FIGS. 13 to 18, the operation will be described below. For the sake of convenience, the small numbers of nozzles and cells 3 are shown in the state transition views of FIGS. 13 to 18.

The table 1 is moved toward the side the inkjet head 10 by the action of the table drive mechanism 22 (Step 201). According to the movement of the table 1, the positional relationship between the nozzles 11a, 11b, ..., and 11n of the inkjet head 10 and the cells 3 of the liquid crystal filter 2 is determined by the computation (Step 202).

As shown in FIGS. 13 to 18, the region of each cell 3 is apparently divided into ten regions in the longitudinal direction by timing pulse signals generated according to the movement of the table 1. The table drive mechanism 22 provides the timing pulse signal to the controller 20. The controller 20 recognizes each region divided from each cell 3 according to the timing pulse signal. The controller 20 recognizes the two regions combining the fifth region and the sixth region as a substantially intermediate region P.

At first, as shown in FIG. 13, the nozzle 11a faces the substantially intermediate region P of the uppermost cell 3 in the first line (YES in Step 203). At this point, the switch Sa of the head drive unit 13 is turned on only for the time intervals corresponding to the four drive pulse voltages. Therefore, the four ink droplets Q having small sizes are continuously ejected from the nozzle 11a (Step 204). The ejected four ink droplets Q having small sizes are thrown into the cell 3. The thrown ink droplets are uniformly distributed in the whole region of the cell 3 and applied to the cell 3. FIG. 14 shows the state in which the ink droplets Q are applied by a hatch pattern.

Then, as shown in FIG. 14, the nozzle 11b faces the substantially intermediate region P of the second uppermost cell 3 in the first line (YES in Step 203). At this point, the switch Sb of the head drive unit 13 is turned on only for the time intervals corresponding to the four drive pulse voltages. Therefore, the four ink droplets Q having small sizes are continuously ejected from the nozzle 11b (Step 204). The ejected four ink droplets Q having small sizes are thrown into the cell 3. The thrown ink droplets are uniformly distributed in the whole region of the cell 3 and applied to the cell 3.

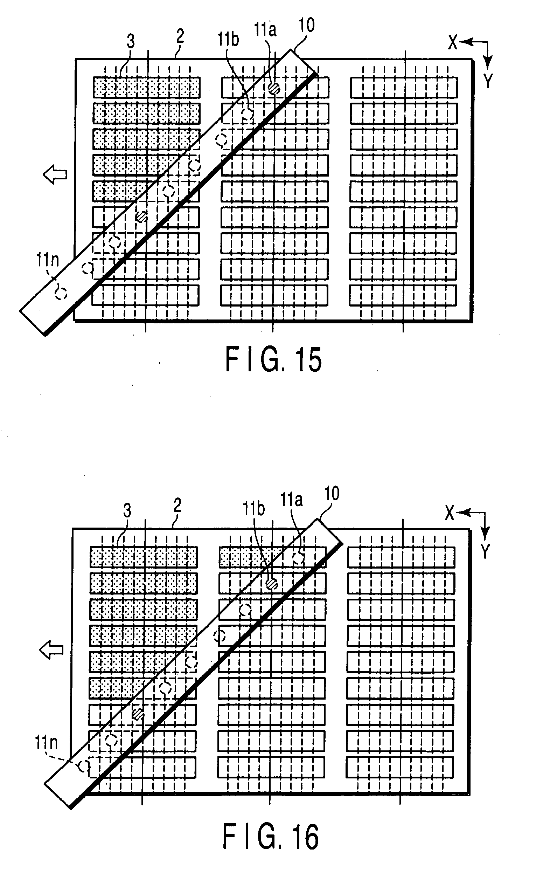

Thus, according to the movement of the liquid crystal filter 2, as shown in FIGS. 15 to 18, the ink droplets Q are sequentially thrown into each cell 3 of the liquid crystal filter 2.

Particularly, FIGS. 15 to 18 show the state in which the two nozzles face the two substantially intermediate regions P of the cells 3. In these cases, the four ink droplets Q having small sizes are continuously ejected from each of the two nozzles. The ejected four ink droplets Q having small sizes are thrown into each of the two cells 3.

In the third embodiment, the four ink droplets Q having small sizes are ejected from each nozzle. However, when the cell 3 has a small area, the number of ink droplets ejected from each nozzle is decreased to three or two.

When the ink droplets Q are applied to all the cells 3 in the liquid crystal filter 2 (YES in Step 205), the movement of the table 1 is stopped (Step 206).

Other configurations, operations, and effects are similar to the first embodiment. Modification

The first to third embodiments have the configuration in which the inkjet head 10 is fixed and the liquid crystal filter 2 is moved. However, it is also possible that the liquid crystal filter 2 is fixed and the inkjet head 10 is moved.

The invention is not effective only in the liquid crystal filter manufacturing apparatus, and is effective in other apparatus.

## Claims

1. A liquid crystal filter manufacturing apparatus in which a plurality of concave cells (3) are arrayed in an upper surface of a translucent plate-shaped member, the apparatus **characterized by** comprising:
an inkjet head (10) having a plurality of nozzles (11a, 11b, ..., and 11n) to eject coloring ink (R, G, B) to said each cell (3), the inkjet head (10) being moved relative to the liquid crystal filter (2); and
a controller (20) which continuously ejects several small ink droplets (Q) from each nozzle (11a, 11b, ..., and 11n) when each nozzle (11a, 11b, ..., and 11n) of the inkjet head (10) faces each cell (3) of the liquid crystal filter (2), so that the ink droplets are not combined together before the ink droplets land on the cell (3) of the crystal filter (2).

2. The apparatus according to claim 1, **characterized in that** the cells (3) of the liquid crystal filter (2) are arrayed in a matrix shape along a relative moving direction between the liquid crystal filter (2) and the inkjet head (10) and along a direction orthogonal to the moving direction.

3. The apparatus according to claim 2, **characterized in that** the nozzles (11a, 11b, ..., and 11n) of the inkjet head (10) are arrayed along the direction orthogonal to the relative moving direction.

4. The apparatus according to claim 3, **characterized in that** the controller (20) has means for adjusting ink (Q) ejection timing of each nozzle (11a, 11b, ..., and 11n) according to position deviation of said each nozzle (11a, 11b, ..., and 11n).

5. The apparatus according to claim 2, **characterized in that** the nozzles (11a, 11b, ..., and 11n) of the inkjet head (10) are arrayed while inclined by a predetermined angle θ with respect to the direction orthogonal to the relative moving direction.

6. The apparatus according to claim 5, **characterized in that** the controller (20) continuously ejects the several ink droplets having the small sizes from any one or the plurality of nozzles (11a, 11b, ..., and 11n) when any one or the plurality of nozzles (11a, 11b, ..., and 11n) of the inkjet head (10) face any one or the plurality of cells (3) of the liquid crystal filter (2).

7. The apparatus according to claim 5, **characterized in that** the controller (20) continuously ejects the several ink (Q) droplets having the small sizes from any one or the plurality of nozzles (11a, 11b, ..., and 11n) when any one or the plurality of nozzles (11a, 11b, ..., and 11n) of the inkjet head (10) face a substantially intermediate region of any one or the plurality of cells (3) of the liquid crystal filter (2).

8. A liquid crystal filter manufacturing apparatus in which a plurality of concave cells (3) are arrayed in an upper surface of a translucent plate-shaped member, the apparatus **characterized by** comprising:
an inkjet head (10) having a plurality of nozzles (11a, 11b, ..., and 11n) to eject coloring ink (R, G, B) to said each cell (3), the inkjet head (10) being moved relative to the liquid crystal filter (2); and
control means for continuously ejecting several small ink (Q) droplets from each nozzle (11a, 11b, ..., and 11n) when each nozzle (11a, 11b, ..., and 11n) of the inkjet head (10) faces each cell (3) of the liquid crystal filter (2), so that the ink droplets are not combined together before the ink droplets land on the cell (3) of the crystal filter (2).

9. The apparatus according to claim 8, **characterized in that** the cells (3) of the liquid crystal filter (2) are arrayed in a matrix shape along a relative moving direction between the liquid crystal filter (2) and the inkjet head (10) and along a direction orthogonal to the moving direction.

10. The apparatus according to claim 9, **characterized in that** the nozzles (11a, 11b, ..., and 11n) of the inkjet head (10) are arrayed along the direction orthogonal to the relative moving direction.

11. The apparatus according to claim 10, **characterized in that** the control means has means for adjusting ink (Q) ejection timing of each nozzle (11a, 11b, ..., and 11n) according to position deviation of said each nozzle (11a, 11b, ..., and 11n).

12. The apparatus according to claim 9, **characterized in that** the nozzles (11a, 11b, ..., and 11n) of the inkjet head (10) are arrayed while inclined by a predetermined angle θ with respect to the direction orthogonal to the relative moving direction.

13. The apparatus according to claim 12, **characterized in that** the control means continuously ejects the several ink (Q) droplets having the small sizes from any one or the plurality of nozzles (11a, 11b, ..., and 11n) when any one or the plurality of nozzles (11a, 11b, ..., and 11n) of the inkjet head (10) face any one or the plurality of cells (3) of the liquid crystal filter (2).

14. The apparatus according to claim 12, **characterized in that** the control means continuously ejects the several ink (Q) droplets having the small sizes from any one or the plurality of nozzles (11a, 11b, ..., and 11n) when any one or the plurality of nozzles (11a, 11b, ..., and 11n) of the inkjet head (10) face a substantially intermediate region of any one or the plurality of cells (3) of the liquid crystal filter (2).

15. A method which controls an inkjet head **characterized by** comprising:
continuously ejecting several small ink droplets from the inkjet head (10), so that the ink droplets are not combine together before the ink droplets land on the surface to be printed.
